# EUROPEAN PATENT SPECIFICATION

(11) **EP 3 802 905 B1**
(45) Date of publication and mention of the grant of the patent: **27.07.2022**
(21) Application number: 19729197.4
(22) Date of filing: 28.05.2019
(51) Int. Cl.: C23C 14/02, C23C 14/58, F16J 9/26, C23C 14/06

(54) **PISTON RING AND METHOD FOR MANUFACTURING A PISTON RING**
KOLBENRING UND VERFAHREN ZUR HERSTELLUNG EINES KOLBENRINGS
SEGMENT DE PISTON ET PROCÉDÉ DE FABRICATION D'UN SEGMENT DE PISTON

(30) Priority: 29.05.2018 US 201815991493
(43) Date of publication of application: 14.04.2021
(73) Proprietor: Mahle International GmbH, 70376 Stuttgart (DE)
(72) Inventor: COOPER, Alexander S., Maple Rapids, Michigan 48853 (US); SMITH, Thomas J., Muskegon, Michigan 49441 (US); STONG, Thomas, Kent City, Michigan 49330 (US); PAUL, Andrea C, Spring Lake, Michigan 49456 (US)
(74) Representative: BRP Renaud & Partner mbB Rechtsanwälte Patentanwälte Steuerberater
(86) International application number: PCT/EP2019/063837
(87) International publication number: WO 2019/229070

(56) References cited:
- EP-A1- 0 707 092
- GB-A- 2 257 771
- GB-A- 2 343 496
- US-A- 5 605 741

## Description

### BACKGROUND OF THE INVENTION

### 1. Field of the Invention

This invention relates to a method for manufacturing a piston ring according to claim 1. In particular, the piston ring is coated with a deposition process and typically a metal nitride coating or a diamond-like carbon (DLC). The invention further relates to a piston ring according to claim 5. In particular, the piston ring is pre-treated with grit blasting to roughen the face and surface of the ring, and then coated via a PVD process with a metal nitride or a diamond-like carbon (DLC) or other coating. The pre-treating increases adhesion of the coating to prevent chipping and flaking during high pressure events, such as LSPI (low speed pre-ignition). The new treatment allows the ring to be unchamfered, as the added adhesion of the coating reduces the risk of chipping the edges of the ring at the ring gap. By eliminating the chamfer, extra processing steps are eliminated and the piston ring can be manufactured more quickly and economically. In addition, the reduced area of the unchamfered ring gap results in a reduction in the blow-by and reduces oil consumption due to the smaller area and improved sealing.

### 2. The Prior Art

Pre-treating piston rings via grit blasting has been used in the past to create a better surface to receive a coating. However, the goal with prior piston rings was to create a surface to which the coating would adhere, yet create a smooth coated surface, to reduce friction with the cylinder walls. For example, US Patent No. 3,556,747 discloses treating the piston ring via grit blasting prior to coating via plasma arc spraying and machining to a smooth finish.

However, particularly with smaller turbo charged engines, LSPI situations can occur, which can lead to increased stress on the engine and consequently on the piston rings. Under this stress, the thin PVD coating can become chipped, leading to increased wear on the cylinder and piston rings.

In addition, most piston rings must be chamfered, to reduce the risk of chipping the edges of the ring at the ring gap during use. Cutting a chamfer into each ring increases the effort and expense during production.

Furthermore, methods for manufacturing piston rings and/or piston rings are also known from EP 0 707 092 A1, US 5 605 741 A, GB 2 343 496 A and GB 2 257 771 A.

### SUMMARY OF THE INVENTION

It is therefore an object of the present invention to provide a coated piston ring that exhibits superior coating retention and durability, yet also retains good lubrication to avoid scuffing on the cylinder liner walls. It is another object of the invention to provide an unchamfered ring that avoids chipping of the edges at the ring gap. The removal of the chamfer at the ring gap improves sealing through reduction of the leak path for combustion blow-by.

This object is accomplished by a piston ring that is pre-treated by grit blasting to a defined roughness, followed by PVD coating with a metal nitride or diamond like carbon (DLC) to a thickness of at least 10µm, leaving peaks and valleys in the coated piston ring. The coated piston ring is then lapped to remove the peaks without penetrating the coating, so that valleys and plateaus remain in the coated surface. The resulting piston ring exhibits superior coating adhesion due to the increased surface area for mechanical interlocking created by the grit blasting, leading to superior coating performance. The cavities remaining increase the porosity of the coating and thus enhance the lubrication of the ring through improved oil retention, reducing potential for wear, scuff and spalling. The piston ring is unchamfered, with the coating applied only on the face side of the ring. And, due to the increased adhesion, the chamfers commonly required to avoid chipping at the ring ends adjacent the gap are no longer a concern.

During high pressure events such as LSPI, explosions in the combustion chamber can lead to very high pressure in the space between the cylinder liner and the piston rings. This pressure situation can cause severe degradation in traditional coatings on the rings. The method of the present invention can minimize or prevent this degradation.

The piston ring is grit blasted to achieve a surface roughness average Rₐ of .3 - 1.5. The grit blasting takes place at angles of 35° and 55° to the face surface of the piston ring. These angles provide the best roughness characteristics, such as the formation of pockets, while also achieving uniform roughness across the piston ring face and chamfer.

The optimal roughness is achieved with a grit size of between 120 and 220, and preferably with a mixture of 120, 180, and 220 grit. The grit can be of any suitable material such as Al₂O₃.

The piston ring can also be treated with a hardening process prior to roughening and coating. This could be either case hardening or through hardening, such as by nitriding the ring.

The coating is a metal nitride, such as CrN or TiN, or a diamond-like carbon coating (DLC) or preferably a carbon film, which exhibits good adhesion in the process according to the invention.

### BRIEF DESCRIPTION OF THE DRAWINGS

Other objects and features of the present invention will become apparent from the following detailed description considered in connection with the accompanying drawings. It is to be understood, however, that the drawings are designed as an illustration only and not as a definition of the limits of the invention.

In the drawings, wherein similar reference characters denote similar elements throughout the several views:
FIG. 1 shows a piston ring having a gap and an unchamfered surface;
FIG. 2 shows the face surface of the ring after grit blasting and coating;
FIG. 3 shows the face surface of the ring after lapping;
FIG. 4 shows the blast angles used during the grit blasting step of the invention;
FIG. 5 shows photographs demonstrating the surface roughness using grit of different sizes and combinations;
FIG. 6 shows photographs illustrating the surface roughness using 35° and 55° blast angles as compared to 5° and 30° blast angles;
FIGS. 7a-7e show comparisons of a surface treated with grits of various sizes and combinations, along with various blast angles;
FIGS. 8a and 8b show a comparison of the prior art chamfered ring gap to a chamferless ring of the present invention;
FIGS. 9a-9c show a comparison of various prior art chamfered ring gaps with the present invention;
FIGS. 10a-10b show a comparison of another prior art chamfered ring with the ring of the present invention; and
FIG. 11 shows a graph of blow-by results during engine testing for a chamferless vs. chamfered piston ring.

### DETAILED DESCRIPTION OF THE PREFERRED EMBODIMENT

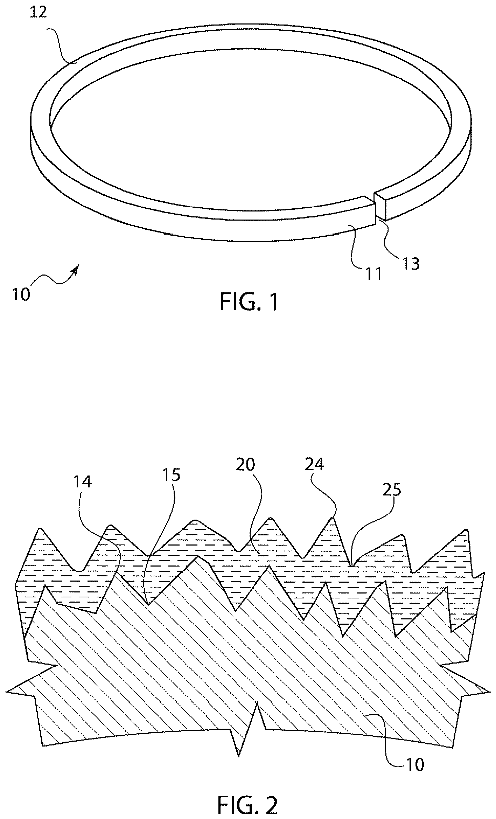

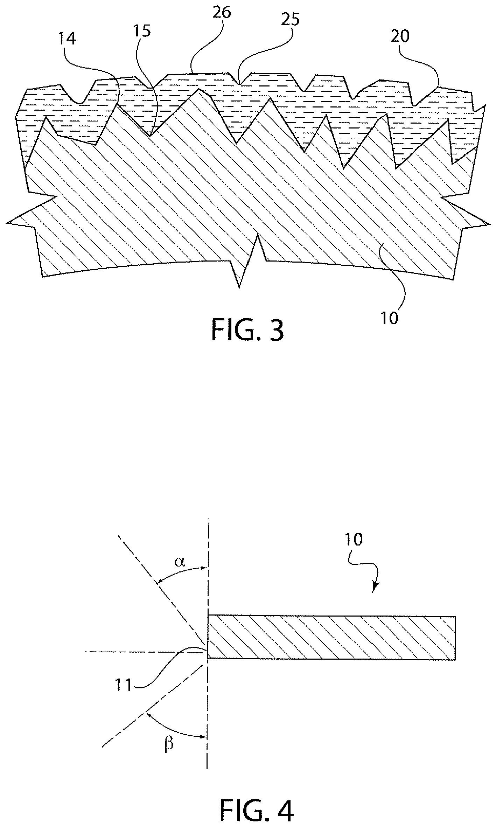

Referring now in detail to the drawings, FIG. 1 shows a piston ring 10 according to the invention. Ring 10 has a face surface 11, a top surface 12, and a gap 13. Face surface 11 is treated with grit blasting, generally with a grit of various sizes, to lead to a surface having a series of peaks 14 and valleys 15, as shown in FIGS. 2 and 3. A coating 20 is applied over the grit-blasted surface via physical vapor deposition (PVD) to a desired depth. Peaks 24 and valleys 25 are also in the coating. Then, as shown in FIG. 3, the peaks 24 of the coating are cut off via a lapping process to form plateaus 26 separated by valleys 25. By finding the optimal grit combinations and blasting angles, the piston ring of the present invention can be manufactured to exhibit high durability during high pressure situations, yet also exhibit high lubrication properties due to the porous nature of the coating. The coating allows for further geometry changes to the ring gap to reduce the amount of blow-by past the piston ring.

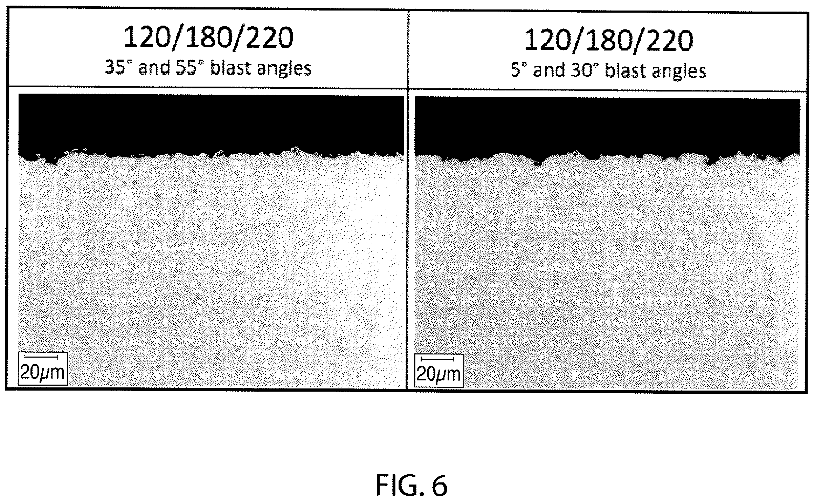

The preferred angles for grit blasting are shown in FIG. 4. An angle α of 35° to the face surface 11, and/or an angle β of 55° to the face surface 11 are used for the grit blasting process. These angles are preferred over smaller and larger angles, as they give a more regular surface effect, and allow for the creation of pockets in the surface of the ring. These pockets increase lubrication retention. A comparison of blast angles is shown in FIG. 6, where using identical grit, blast angles of 35° and 55° are compared to blast angles of 5° and 30° for the face surfaces of a piston ring according to the invention. As shown in FIG. 6, the blast angles of 35° and 55° show overall higher regularity in the surface, yet also allow for the creation of pockets in the surfaces.

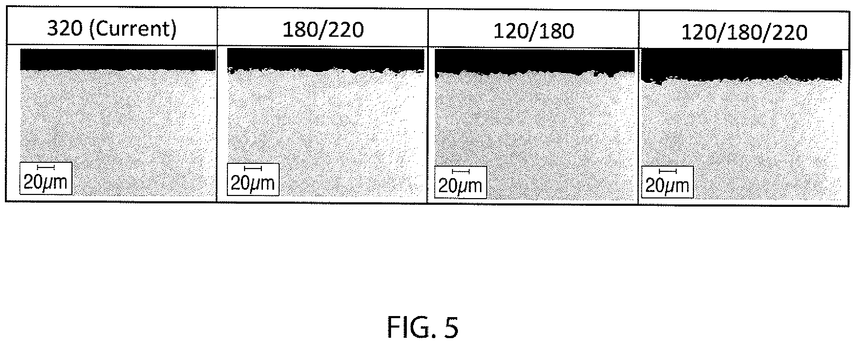

FIG. 5 shows a comparison of surface textures of the face surface for various grit sizes and combinations. After experimentation, it was determined that a combination of grit sizes of 120/180/220 grit leads to the best surface regularity and roughness. The grit is used in a 1:1:1 ratio. The use of 120 grit media increases the overall roughness of the surface, while greater regularity is achieved with the addition of 220 grit media. The commonly used 320 grit media is shown for comparison. As can be seen, using grit between 120-180 leads to significantly rougher surfaces than when 320 grit is used.

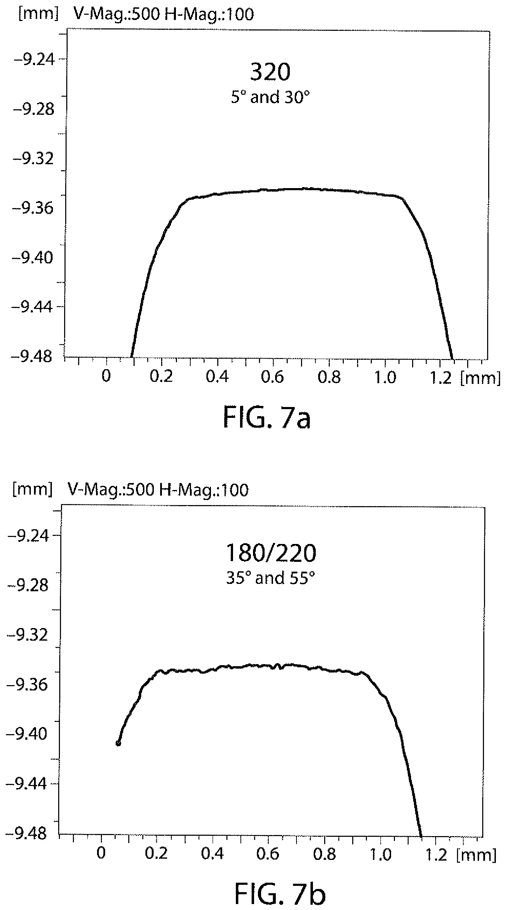

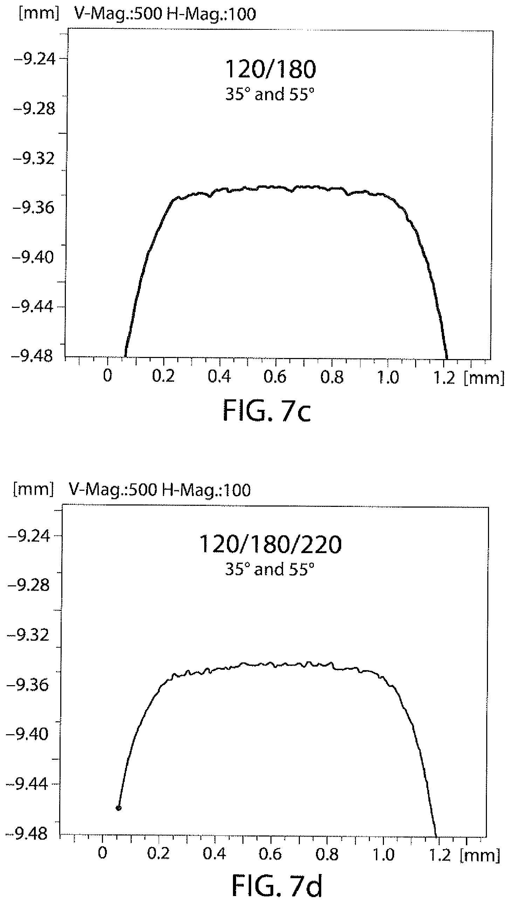

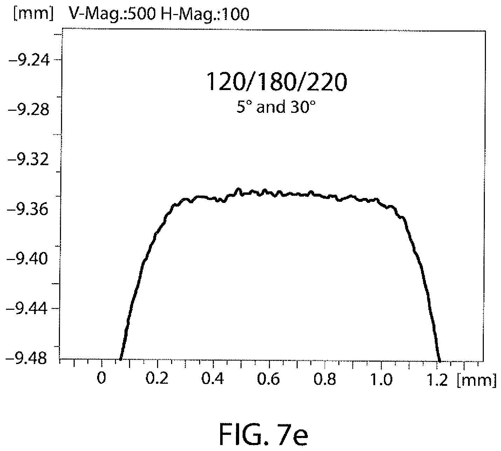

FIGS. 7a-7e show comparisons of a surface treated with grits of various sizes and combinations, along with various blast angles. FIG. 7a shows the use of 320 grit and 5° and 30° blast angles. The treated surface is relatively smooth. FIG. 7b shows treatment with 180/220 grit at 35° and 55° blast angles. This leads to significantly rougher texture on the surface. In comparison, FIG. 7c uses the same blast angles, but increases the grit size to 120/180. This leads to an even rougher surface but with uneven peaks and valleys. The preferred 120/180/220 grit combination, with the preferred angles of 35° and 55° is shown in FIG. 7d. Here, the surface is uniformly roughened. Changing the blast angles to 5° and 30°, as shown in FIG. 7e, leads to less uniformity in the roughness.

Table 1 below illustrates the comparative average roughness using the various grit sizes and blast angles.

**Table 1**

| | Face | |
|---|---|---|
| | Rₐ | R_{z} |
| 320 | 0.30 | 2.12 |
| 5° and 30° | | |
| 120/180 | 0.87 | 6.66 |
| 35° and 55° | | |
| 180/220 | 1.02 | 6.99 |
| 35° and 55° | | |
| 120/180/220 | 0.85 | 6.28 |
| 35° and 55° | | |
| 120/180/220 | 1. 99 | 9.05 |
| 5° and 30° | | |

As can be seen above, the combination of 120/180/220 grit and the 35° and 55° blast angles gives a slightly lesser roughness in the face surface than 120/180 grit or different blast angles. This is optimal to create the best profile for performance of the rings. If the face surface is too rough, scuffing or bore marking of the cylinder liner can occur. However, for automotive applications, the removal of peaks through the lapping operation should be sufficient to eliminate this problem, as is supported by the results of the first engine test.

In addition, having a slightly smoother face surface is optimal for uniformity of coating thickness and minimization of lapping time. High face roughness will require more lapping to remove during manufacturing, adding cost and resulting in a coating which fluctuates between thick and thin - thick in valleys, thin where peaks have been lapped off. This might also require increased coating thickness in order for the thin spots to be thick enough, which would add further time and cost to the manufacturing process.

As shown in FIG. 5, using the 120/180/220 grit leads to more surface features than the 120/180 grit in both the face and chamfer region, and these features provide superior mechanical locking strength due to the increased roughness of the substrate while still providing for a manufacturing-friendly process.

The rings of the present invention were also tested to see if the grit blasting had any significant effect on light tightness, ring tension and the size of the free gap in the ring. 88.1 mm rings and 92.5 mm prototype pieces were tested. Piston rings having the variations of grit blasting as shown in FIGS. 7a-7e exhibited suitable light tightness and acceptable tension and ring gap sizes that varied only slightly from an untreated ring. Thus, the addition of grit up to 120 in size had negligible effects on the ring free gap and tension and no adverse effects on light tightness, yet had significant effects on the surface roughness of the ring face, giving the beneficial effects discussed above.

**Table 2**

| **Grit** | **Free gap (mm)** | **CD Tension (N)** | **Light Tightness** |
|---|---|---|---|
| None | 12.64 | 23.5 | good |
| 320 | 12.51 | 23.5 | good |
| 180/220 | 12.56 | 23.1 | good |
| 120/180 | 12.17 | 22.6 | good |
| 120/180 (after 250°C) | 12.18 | 22.8 | good |
| 120/180/220 (35° and 55°) | 11.97 | 22.3 | good |
| 120/180/220 (5° and 30°) | 12.56 | 22.2 | good |

Table 3 illustrates tests run on 88.1 mm piston rings and 92.5 mm prototypes that were treated with grit blasting and subjected to heating for 5 hours at 250°C to illustrate furnace conditions of a PVD chamber. As shown in the table this treatment had a negligible effect on the ring characteristics.

**Table 3**

| **Diameter (mm)** | **Condition** | **Free gap (mm)** | **CD Tension (N)** | **Light Tightness** |
|---|---|---|---|---|
| 88.1 | 120/180 Blasted | 12.17 | 22.6 | good |
| | After 250°C for 5hrs | 12.18 | 22.8 | good |
| 92.5 | 120/180 Blasted | 14.18 | 21.4 | good |
| | After 250°C for 5hrs | 14.22 | 21.4 | good |

In addition, tests were conducted in an internal combustion engine, using the rings according to the invention. A minimum of 400 LSPI events occurred in the engine, with an average event pressure of about 190 bar. The rings according to the invention exhibited a 50% minimum area reduction in running face coating loss as compared to a standard ring treated with only 320 grit, and exhibited no scuffing or bore marking on the cylinder liner. In the exemplary form, the testing has exhibited 93% reduction in coating loss, demonstrating a significant improvement in adhesion strength.

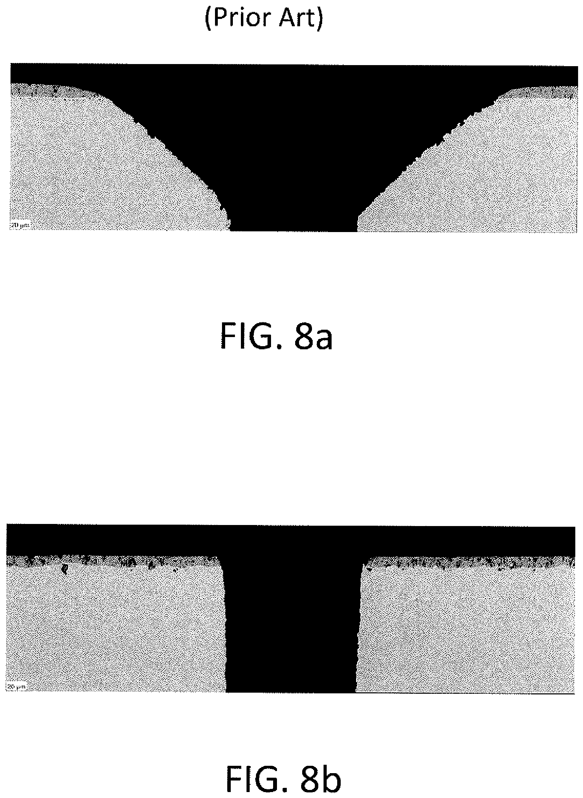

FIG. 8a shows a magnified image of the ring ends of a prior art PVD piston ring, illustrating the large leak path of current PVD piston rings. The prior art piston ring includes a large chamfer to protect the ring ends and to reduce the likelihood of chipping of the coating at the ring ends. The ring ends are typically an area of the piston ring that have seen higher contact forces with the cylinder wall, and various chamfer shapes and radii have been used in an attempt to minimize any PVD coating damage in this area. The prior art ring as illustrated here uses a chamfer to protect the PVD coating from chipping near the ring gap, but also enlarges the gap and gas leak path of the piston ring.

The present invention further provides advantages associated with reducing the possibility of blow-by due to the smaller ring gap with the unchamfered geometry. Blow-by is commonly known as the amount of combustion gases, fuel, and lubricating oils that are able to pass the piston rings. The majority of this blow-by is commonly caused by the passage created at the ring gap. The ring gap previously required a chamfer to protect the coating edge and avoid chipping of the PVD coating, and the chamfer greatly increases the area of the ring gap, or leak path. Therefore, any reduction in the area of the ring gap reduces the propensity for blow-by, decreasing the amount of gas that is able to pass downward into the oil sump or oil passing upwards into the combustion chamber. The piston ring, when it is installed on the piston and compressed into the diameter of the cylinder liner, will decrease the ring gap, due to the compression of the piston ring, and this is known as the working gap of the piston ring.

The present invention and the unique coating increases adhesion, and allows for the piston ring to be manufactured without a chamfer, thereby decreasing the piston ring gap area. Therefore, the gas leak path area is greatly decreased, further reducing the possible blow-by gases into the combustion chamber.

One example of the current invention is illustrated in FIG. 8b, where the chamfer is minimized to the lower end of manufacturability and thereby greatly reduces the leak path area when compared to the ring of FIG. 8a. The ring of the invention utilizes the blast process as described above, and due to the improved adhesion, the chamfer may be removed from the piston ring, since chipping is no longer a concern with the improved locking feature of the blasting process discussed in detail above.

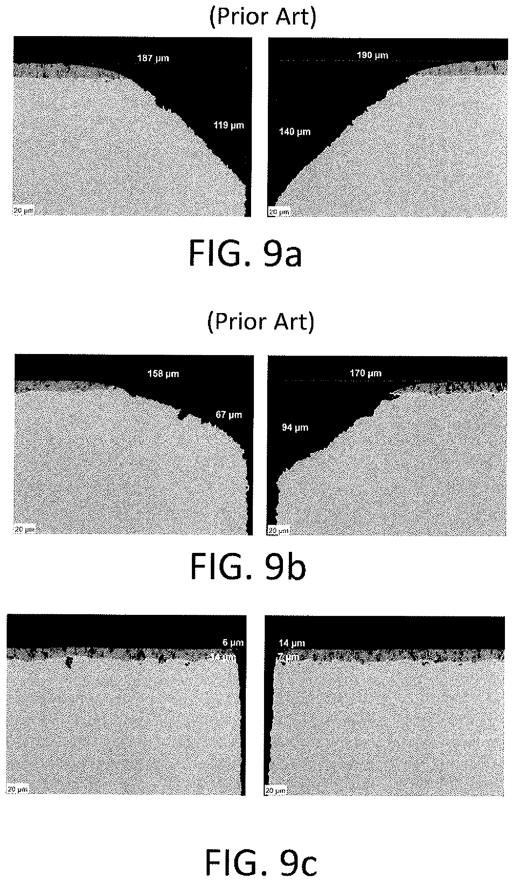

The chamfer leak path of the present invention is reduced from that of prior art by as much as 99%. The elimination of the chamfer on the ring ends reduces and minimizes the gas leak path and thereby minimizes the blow-by. FIGS. 9a, 9b and 9c all illustrate the further details of the changes from the prior art production in Figs. 9a and 9b to the chamferless or unchamfered ring gap shown in FIG. 9c. Table 4 below further describes the reduction of the estimated leak path for one diameter of the rings from prior art as compared to an example of the subject invention.

**Table 4**

| **Ring** | **Horizontal Dimension (µm)** | **Veritcal Dimension (µm)** | **Estimated Gas Leak Path (µm²)** |
|---|---|---|---|
| FIG 9a-left | 187 | 119 | 11127 |
| FIG 9a-right | 190 | 140 | 13300 |
| **FIG 9a** **Estimated Total Gap** | | | **24427** |
| FIG 9b-left | 158 | 67 | 5293 |
| FIG 9b-right | 170 | 94 | 7990 |
| **FIG 9b** **Estimated Total Gap** | | | **13283** |
| FIG 9c-left | 6 | 14 | 42 |
| FIG9c-right | 14 | 7 | 48 |
| **FIG 9c** **Estimated Total Gap** | | | **91** |

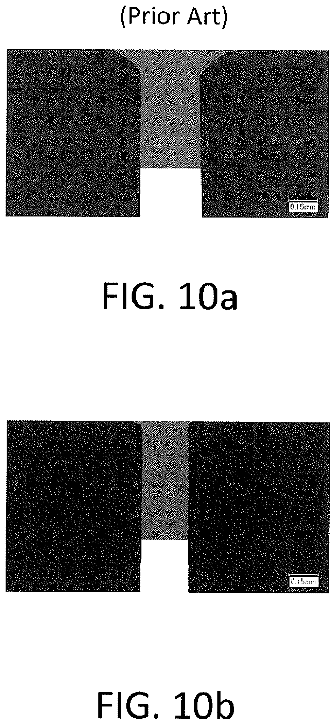

FIG. 10a illustrates an enhanced image of a smaller chamfered prior art piston ring. The coating is a thermal spray, which is less prone to the risks of chipping due to the bonding of the molten coating, but even the smallest chamfer is significantly larger than the present invention as shown in see FIG. 10b. The chamfered ring includes a larger orifice area by 10% and 27% greater gas leak path. The smaller chamfered ring of FIG. 10a also exhibited blow-by (L/min) that was approximately 10% greater.

FIG. 10b is an enhanced image and illustrates the sharper chamferless corner at the ring gap. The coating is applied by a PVD process, and this geometry is possible without concern of chipping due to the improved adhesion of the coating process discussed above. The chamferless corner has a width equal to or less than 0.05 mm. This is a manufacturing tolerance for the straight end, and as close to a sharp corner as possible. The chamfer is measured via calculating the hypotenuse, from the two legs of the straight end. As illustrated in FIGS. 9a-9c, the chamfer is calculated using these legs and Pythagorean theorem, a²+b²=c².

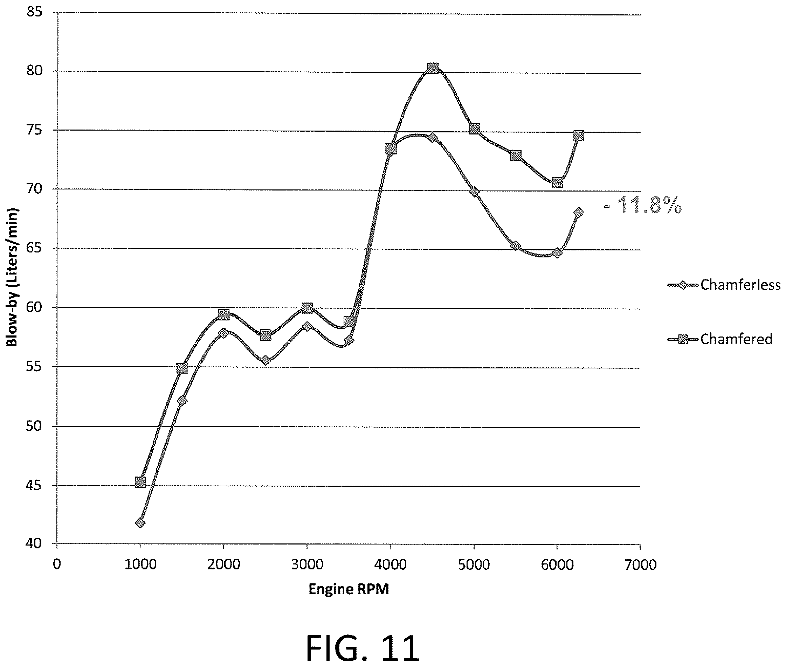

In one example, the chamferless or unchamfered rings reduce the blow-by by over 25% and reduce the working gap by 90%. The graph in FIG. 11 illustrates another example of the present invention, showing that the chamferless piston ring had an average decrease of 6% less blow-by than the baseline, and at higher engine RPMs, the decrease may be as high as 12%.

## Claims

1. A method for manufacturing a piston ring, comprising;
providing a piston ring base having an unchamfered face surface, and a gap between two gap surfaces of the ring;
grit blasting the face surface to create a roughened texture having an average surface roughness Rₐ of .3µm - 1.5µm;
depositing a coating on the roughened face surface and chamfer surface via physical vapor deposition; and
lapping the coating to remove peaks in the surfaces without penetrating the coating, so that the coated surfaces contain plateaus and valleys; wherein
the grit blasting is applied with a grit size of between 120 and 220; wherein
the grit blasting takes place at angles of 35° and 55° to the face surface of the piston ring; wherein
the coating is a metal nitride or a diamond-like carbon (DLC).

2. The method according to claim 1, wherein the grit is formed from a mixture of 120, 180 and 220 grit.

3. The method according to claim 1, wherein the coating is applied at a thickness of at least 10µm.

4. The method according to claim 1, further comprising hardening the piston ring prior to grit blasting via a case hardening or through hardening process.

5. A piston ring comprising:
a ring formed of a base material and having an unchamfered face surface that is surface roughened to a roughness average of between 0.3µm - 1.5µm Rₐ and two gap surfaces with a ring gap there between; and
a coating disposed on at least the face surface, the coating being deposited by physical vapor deposition and then lapped to remove peaks without penetrating the coating, so that the surface of the piston ring contains plateaus and valleys; wherein
the coating is formed of a metal nitride or a diamond-like carbon (DLC).

6. The piston ring according to claim 5, wherein the ring is made of steel that has been hardened via a case hardening or through hardening process.

7. The piston ring according to claim 5, wherein a corner formed between the face surface and a top surface of the ring has a width is equal to or less than 0.05mm.

## Patentansprüche

1. Verfahren zur Herstellung eines Kolbenrings, das Folgendes umfasst:
das Bereitstellen eines Kolbenring-Grundkörpers mit einer ungefasten Stirnfläche und einem Spalt zwischen zwei Spaltflächen des Rings;
das Abstrahlen der Stirnfläche zum Erzeugen einer aufgerauten Textur mit einer mittleren Oberflächenrauheit Rₐ von 0,3 µm -1,5 µm;
das Abscheiden einer Beschichtung auf der aufgerauten Stirnfläche und der Fasenfläche mittels einer physikalischen Gasphasenabscheidung und
das Läppen der Beschichtung zum Entfernen von Erhebungen in den Flächen, ohne die Beschichtung zu durchdringen, sodass die beschichteten Flächen Plateaus und Mulden enthalten; wobei
das Abstrahlen mit einer Strahlmittelgröße zwischen 120 und 220 erfolgt; wobei
das Abstrahlen bei Winkeln von 35° und 55° zur Stirnfläche des Kolbenrings erfolgt; wobei
die Beschichtung ein Metallnitrid oder ein diamantartiger Kohlenstoff (DLC) ist.

2. Verfahren nach Anspruch 1, wobei das Strahlmittel aus einem Gemisch mit einer Körnung von 120, 180 und 220 besteht.

3. Verfahren nach Anspruch 1, wobei die Beschichtung mit einer Dicke von mindestens 10 µm aufgetragen wird.

4. Verfahren nach Anspruch 1, das weiterhin das Härten des Kolbenrings vor dem Abstrahlen mittels eines Einsatzhärtungs- oder Durchhärtungsprozesses umfasst.

5. Kolbenring, der Folgendes umfasst:
einen Ring, der aus einem Grundwerkstoff besteht und eine ungefaste Stirnfläche, deren Oberfläche zu einem Mittenrauhwert Rₐ zwischen 0,3 µm - 1,5 µm aufgeraut ist, und zwei Spaltflächen mit einem Ringspalt dazwischen aufweist; und
eine Beschichtung, die zumindest auf der Stirnfläche abgeschieden ist, wobei die Beschichtung mittels einer physikalischen Gasphasenabscheidung abgeschieden und dann geläppt wird, um Erhebungen zu entfernen, ohne die Beschichtung zu durchdringen, sodass die Oberfläche des Kolbenrings Plateaus und Mulden enthält; wobei
die Beschichtung aus einem Metallnitrid oder einem diamantartigen Kohlenstoff (DLC) besteht.

6. Kolbenring nach Anspruch 5, wobei der Ring aus Stahl besteht, der mittels eines Einsatzhärtungs- oder Durchhärtungsprozesses gehärtet worden ist.

7. Kolbenring nach Anspruch 5, wobei eine Ecke, die zwischen der Stirnfläche und einer Oberseite des Rings gebildet ist, eine Breite gleich oder kleiner als 0,05 mm aufweist.

## Revendications

1. Procédé de fabrication d'un segment de piston, comprenant les étapes consistant à ;
fournir une base de segment de piston présentant une surface frontale non chanfreinée, et un espace entre deux surfaces d'espace du segment ;
grenailler la surface frontale pour créer une texture rugueuse présentant une rugosité moyenne de surface Rₐ de 0,3 µm-1,5 µm ;
déposer un revêtement sur la surface frontale rugueuse et la surface de chanfrein par dépôt physique en phase vapeur ; et
roder le revêtement pour éliminer les pics dans les surfaces sans pénétrer dans le revêtement, de sorte que les surfaces revêtues contiennent des plateaux et des vallées ; dans lequel
le grenaillage est appliqué avec une grosseur de grain abrasif entre 120 et 220 ; dans lequel
le grenaillage a lieu à des angles de 35° et 55° par rapport à la surface frontale du segment de piston ; dans lequel
le revêtement est un nitrure de métal ou un carbone sous forme de diamant (CDA).

2. Procédé selon la revendication 1, dans lequel le grain abrasif est formé d'un mélange de grains abrasifs 120, 180 et 220.

3. Procédé selon la revendication 1, dans lequel le revêtement est appliqué à une épaisseur d'au moins 10 µm.

4. Procédé selon la revendication 1, comprenant en outre le durcissement du segment de piston avant le grenaillage via un procédé de cémentation ou de durcissement par trempe à cœur.

5. Segment de piston comprenant :
un segment formé d'un matériau de base et présentant une surface frontale non chanfreinée qui est rendue rugueuse en surface jusqu'à une rugosité moyenne entre 0,3 µm-1,5 µm de Rₐ et deux surfaces d'espace avec un espace de segment entre elles ; et
un revêtement disposé sur au moins la surface frontale, le revêtement étant déposé par dépôt physique en phase vapeur et ensuite rodé pour éliminer les pics sans pénétrer dans le revêtement, de sorte que la surface du segment de piston contient des plateaux et des vallées ; dans lequel
le revêtement est formé d'un nitrure de métal ou d'un carbone sous forme de diamant (CDA).

6. Segment de piston selon la revendication 5, dans lequel le segment est fait d'un acier qui a été durci par un procédé de cémentation ou de durcissement par trempe à cœur.

7. Segment de piston selon la revendication 5, dans lequel un coin formé entre la surface frontale et une surface supérieure du segment présente une largeur inférieure ou égale à 0,05 mm.
